# EUROPEAN PATENT SPECIFICATION

(11) **EP 0 632 543 B1**
(45) Date of publication and mention of the grant of the patent: **09.12.1998**
(21) Application number: 94110114.9
(22) Date of filing: 29.06.1994
(51) Int. Cl.: H01R 23/70

(54) **Solderless boardlock**
Lötfreie Steckverrieglung für eine Leiterplatte
Elément de blocage sans soudure pour plaquette de circuit imprimé

(30) Priority: 30.06.1993 GB 9313492
(43) Date of publication of application: 04.01.1995
(73) Proprietor: THE WHITAKER CORPORATION, Wilmington, Delaware 19808 (US)
(72) Inventor: Krämer, Rudolf, D-64686 Lautertal (DE); Schaarschmidt, Manfred, D-64625 Bensheim (DE)
(74) Representative: Klunker . Schmitt-Nilson . Hirsch

(56) References cited:
- EP-A- 0 250 097
- EP-A- 0 366 964
- EP-A- 0 492 017
- WO-A-79/01050
- US-A- 2 329 471
- US-A- 2 755 453

## Description

This invention relates to a boardlock according to the preamble of claim 1.

A multitude of different boardlocks are used in the electronics industry for securing an electrical connector or device to a printed circuit board. Some boardlocks are first securely mounted to a connector, and have resilient legs extending therebelow that are engageable in a hole of a printed circuit board for provisionally holding the connector to the printed circuit board. Examples of such boardlocks are disclosed in US patents 5108312 and 5115375. The boardlocks serve to provisionally hold the connector to the printed circuit board during assembly of other electrical devices. Once the electrical devices are all assembled to the printed circuit board, the board is then taken to a soldering station whereby the electrical connections to the circuit board are permanently soldered thereon, the resilient legs of the boardlock also receiving solder thus being permanently and rigidly secured to the printed circuit board.

Other boardlocks such as in US patent 4717219, do not have resilient legs but instead are inserted through the printed circuit board and then plastically deformed such that they can not be extracted. Post-soldering of these boardlocks is also usually foreseen, because the boardlocks do not hold the device or connector sufficiently securely to the printed circuit board. A further problem with the deformable boardlocks if they don't have resilient legs, is that they can not provisionally hold the connector or device to the printed circuit board during the assembly procedure.

From document EP-A1-0 366 964 a connector with a barbed boardlock has come to be known. Said known boardlock is a unitary edge-stamped sheet metal part comprising a U-shaped substantially planar and symmetrical board mounting section and a connector mounting section. The board mounting section comprises a pair of arms joined at a low end by a bridge portion, whereby the arms are insertable in a hole in the printed circuit board and whereby the bridge portion is insertable through a hole in the printed circuit board. This known boardlock is fixed by a deformation of the arms.

From document EP-A1-0 250 097 an electrical connector for assembly onto a circuit board has come to be known. This known electrical connector has an eyelet disposed in an aperture in a mounting flange. The eyelet is received in an aperture in an interference fit. The eyelet has a flange engaging the mounting flange of a housing of the connector, an inverted conical end remote from the flange, and a generally tubular shank extending therebetween. A first section of the shank provides the interference fit with the aperture. A second section of the shank extends below the mounting flange for disposition within an aperture in the printed circuit board. The second section may be tapered or of a similar diameter than the first section. The inverted conical end is splayed or expanded into contact with the printed circuit board by activation through the bore of said tubular shank to secure the electrical connector assembly to the printed circuit board. This document does not disclose a unitary edge-stamped sheet metal part forming a boardlock.

From document US-A-2,755,453 an electrical terminal has come to be known, comprising a flat sheet metal shank and a flat sheet metal head integrally attached to said shank; said shank being provided with at least one hole therein to provide inner walls; said shank having its outer edges notched, the boundary of said notches defining, together with said inner walls, a pair of legs integral with said shank, attached thereto at both ends and inclined at an angle to the length thereof; at least a portion of said legs being adapted to be bent away from each other.

The above boardlocks, although stamped from sheet metal, are relatively complicated and expensive to manufacture.

It is also desirable in the electronics industry to provide a boardlock that doesn't require post-soldering because an increasing number of connectors are being connected to printed circuit boards via compliant pins that require no soldering. The latter is advantageous because it eliminates the need for an extra manufacturing step, namely the soldering process.

It is therefore an object of this invention to provide a cheap and reliable boardlock for connecting an electrical device to a printed circuit board without requiring post-soldering.

It is a further object of this invention to provide a boardlock with minimal space requirements.

These objects have been solved according to the invention by a boardlock for mechanical fixing a connector to a printed circuit board exhibiting the features as set out in claim 1. Dependent claims 2 to 10 exhibit further improvements thereof.

A boardlock is provided that is a unitary edge stamped sheet metal part comprising a U-shaped board mounting section and a connector mounting section, the board mounting section comprising a pair of rigid arms joined at a lower end by a deformable bridge portion whereby the rigid arms and the bridge portion are insertable through a hole in a printed circuit board and the bridge portion is permanently deformable such that the boardlock is held securely to the board.

The preferred embodiment of this invention will now be described in more detail with reference to the drawing figures, whereby;
Figure 1 is a plan view of a boardlock prior to assembly in a connector;
Figure 2 is a plan view of the boardlock of Figure 1, inserted through a hole of a printed circuit board and about to be deformed by a die;
Figure 3 is the same view as Figure 2 whereby the boardlock is permanently deformed by the die;
Figure 4 is a view of a boardlock assembled to a right angled connector about to be mounted to a printed circuit board;
Figure 5 is a top view of a die;
Figure 6 is a cross sectional view through a boardlock mounted in a connector housing;
Figure 7 is a plan view of another embodiment of a boardlock;
Figure 8 is the boardlock of Figure 7 inserted through a circuit board hole and about to be deformed by a die; and
Figure 9 is a similar view to Figure 8 but with the boardlock permanently deformed by the die.

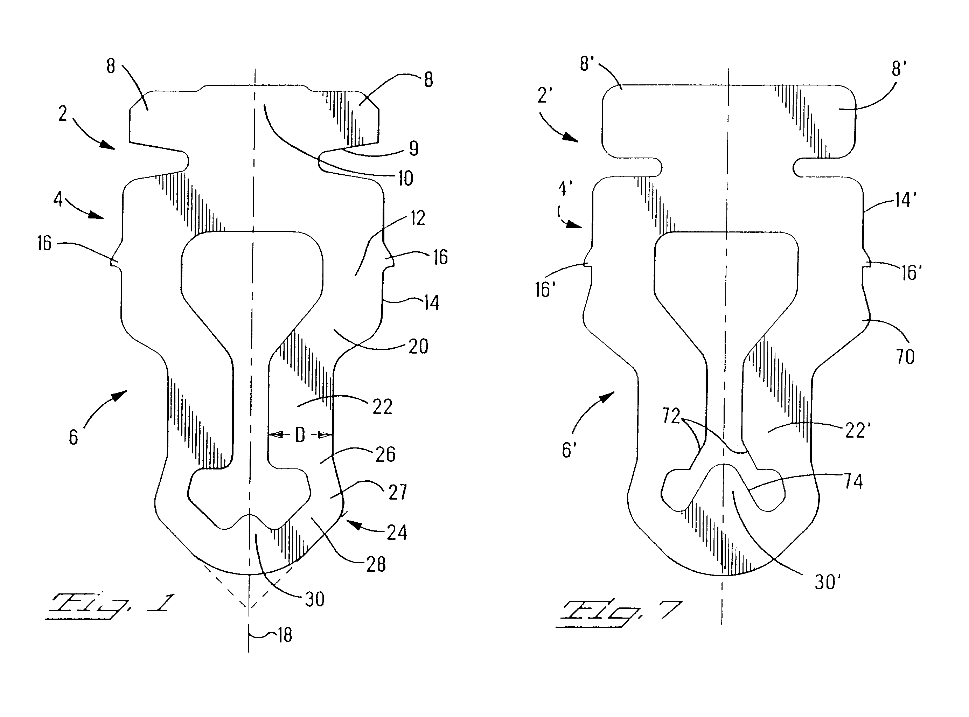

With reference to Figure 1, a boardlock generally shown at 2 comprises a connector retention section 4 and a printed circuit board connection section 6. The connector section comprises a pair of mirror image deformable mounting tabs 8 attached at an upper end of a central body portion 10, the tabs 8 having a lower inclined edge 9 for engaging a connector housing shoulder. The connector section 4 also comprises a pair of spaced apart guiding legs 12 that have an outer edge 14 and projecting outwards from the outer edge 14 are interference fit retention barbs 16. The connector section 4 and the boardlock section 6 are disposed in mirror image symmetry about a central axis 18. To the guide arms 14 is attached the board connecting section 6 via transitional arm portions 20. The board connecting section 6 comprises rigid spaced apart arms 22 having a thickness D, the rigid arms 22 spaced apart at a lesser distance than the guide arms 14. The board section 6 further comprises a deformable bridge portion generally shown at 24 that extends below the rigid arms and makes connection therebetween. The bridge portion 24 comprises a first bridge portion 26 extending obliquely outwardly and downwardly from the lower portion of the rigid arms 22, and a second bridge portion 28 extending obliquely inwardly and downwardly towards a bridge center portion 30 disposed about the axis 18 of the boardlock. The first and second bridge portions are of a lesser thickness than the thickness D of the rigid arms. The center bridge portion 30 is of greater thickness than the bridge arm section whereby the added thickness projects inwardly of the boardlock.

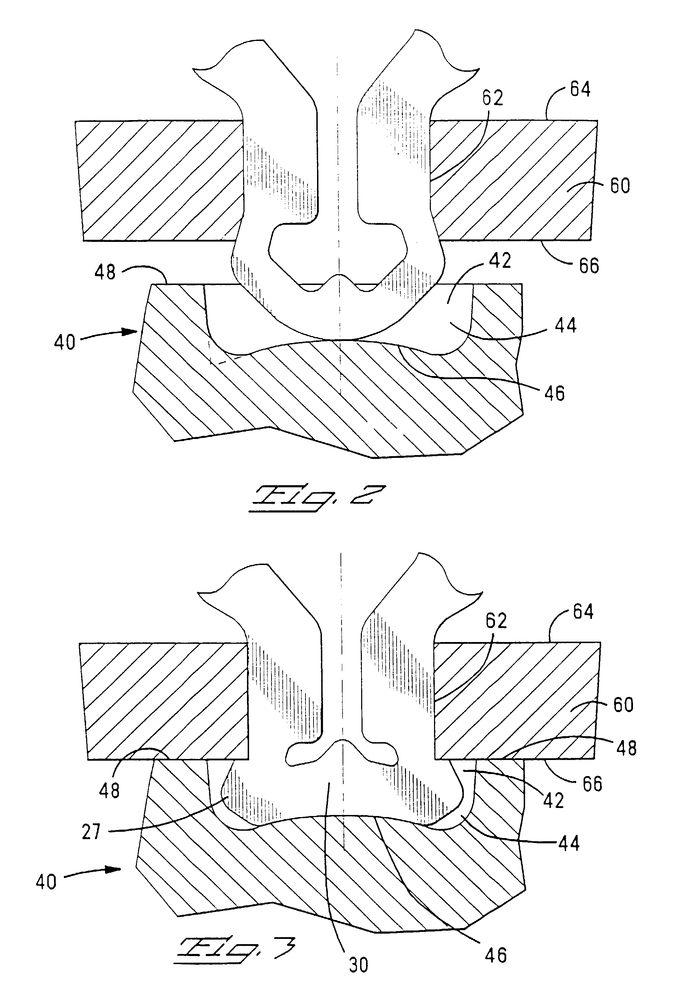

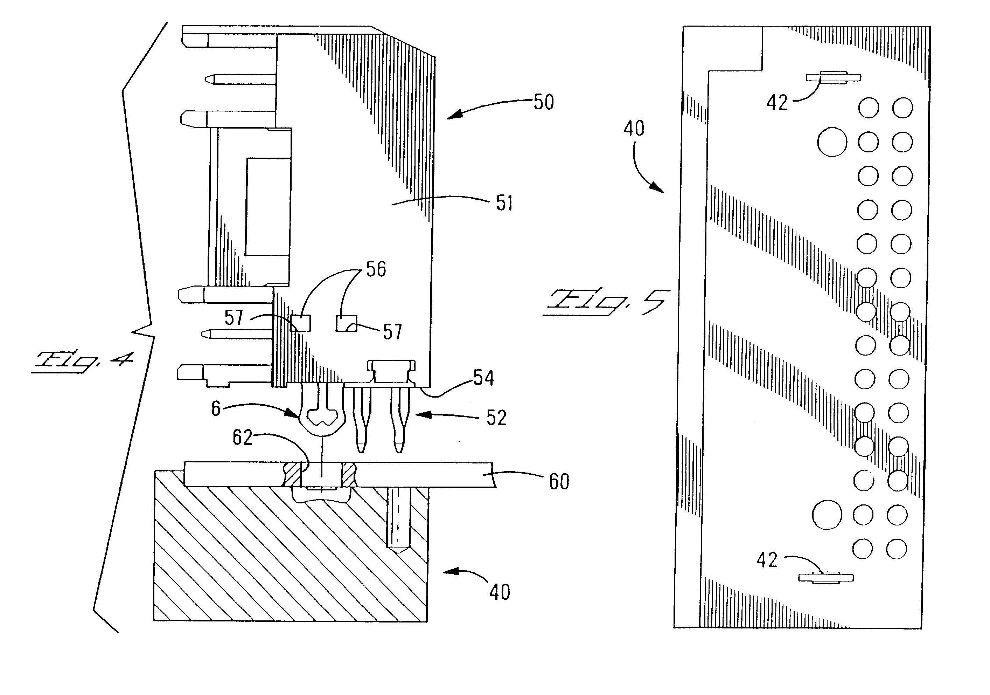

With reference now to Figures 2 and 3, a die 40 partially shown in cross section comprises an elongate boardlock receiving cavity 42 having lateral front and back walls 44, and a convex bottom wall 46.

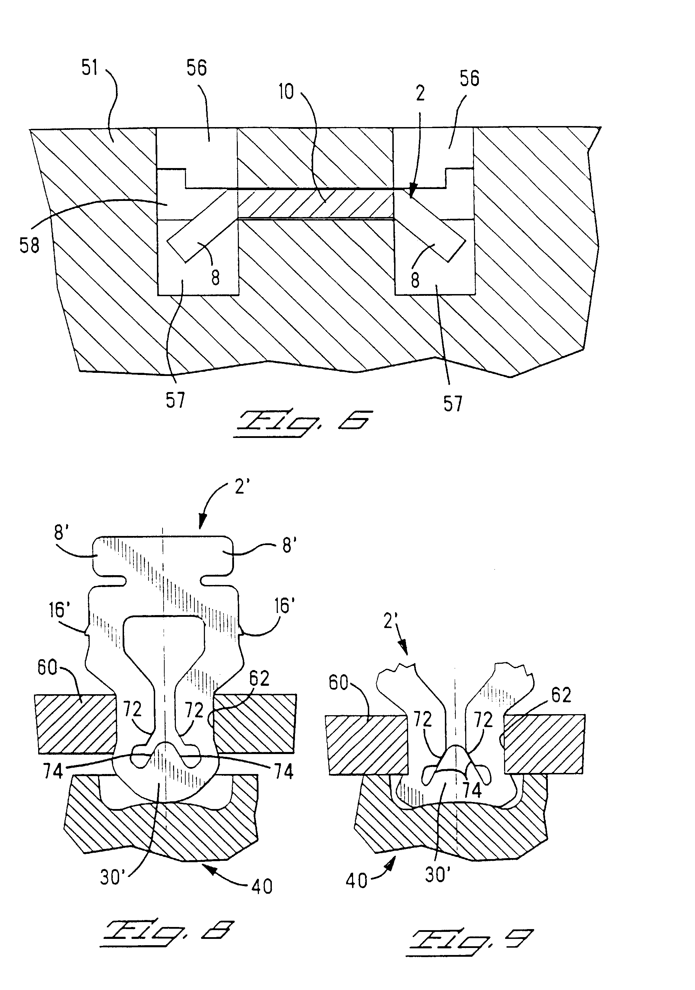

With reference now to Figure 4, an electrical connector generally shown at 50 comprises a housing 51, a plurality of compliant pins 52 projecting below a printed circuit board mating face 54, and a pair of boardlock retention window cavities 56. Within the window cavities 56 is a shoulder 57 engageable against deformed tabs of a boardlock for retention thereof. The connector 50 also comprises boardlock receiving cavities 58.

Referring back to Figure 2, 3 and 4, a printed circuit board 60 is shown comprising a cylindrical boardlock receiving hole 62.

Referring to Figure 2, the boardlock 2 is shown already mounted into the hole 62 of the printed circuit board. The rigid arms 22 are comprised within the hole 62 and are spaced apart such that they press against the outer diameter thereof and because the boardlock is a substantially flat edge stamped sheet metal part, the plane of the rigid arms corresponds roughly to a plane that includes the axis of the hole 62.Extending outwardly of the hole, are the first bridge arm portions 26 and in order to assemble the boardlock to the printed circuit board, the bridge arm first and second portions 26,28 are elastically deformable towards the axis 18 such that the boardlock can be inserted from the upper side 64 of the board 60 through the hole 62. Once the boardlock is fully inserted into the hole 62, the first bridge portion thus bulges outwards of the hole 62 thereby provisionally and elastically securing the boardlock thereto. Figure 2 shows the die 40 on the point of engaging the boardlock. The side walls 44 of the die are spaced apart at a distance only slightly greater than the thickness of the boardlock such that they act as a guide and prevent the boardlock from bending out of its planarity. The boardlock is a thin sheet metal part, and unless it is guided such that it stays flat, any deformation force will tend to bend the bridge portion of the boardlock out of its plane; and particularly so because the hole 62 is circular and provides no lateral support of the boardlock.

Now referring to Figure 3, an upper surface 48 of the die is shown pressed against a lower surface 66 of the printed circuit board 60, the bridge portion 24 of the boardlock consequently being plastically deformed such that the first bridge portion partially deforms around the corner of the edge of the hole 62; and the outer portions 27 bulge even further outwards of the hole 62 than in the undeformed position. The boardlock is thus held securely and permanently to the board 60 and cannot be extracted by an upwards pulling force. Outwards deformation of the bridge outer portions 27 is ensured because the first 26 and second 28 bridge portions which are of lesser width than the rigid arms 22, are obliquely and outwardly slanted towards the outer portions 27. The convex shape of the die bottom wall and hence that of the deformed boardlock center portion 30, has a particular purpose as will become apparent below.

The arcuatly deformed bridge portion of the boardlock serves to enhance the strength with which the boardlock is retained to the printed circuit board. A large extraction force applied to the boardlock will be taken up by the deformed outer portions 27 that press against the lower surface 66 of the printed circuit board at the outer edge of the hole 62, whereby this force will cause a moment that will tend to pivot the center portion 30 upwards towards the connector. If this force is large enough to cause plastic deformation, the bridge portion will further buckle, but this buckling will be inhibited by the bridge portion 24 abutting the lower end of the rigid arms 22. If the forces on the boardlock are such, however, that the center portion 30 attempts to pivot downwardly away from the connector 50, then this will tend to force the bulge portions 27 even more further outwards as the arcuate shape will tend to straighten out and thus increase the distance between the bulge portions 27. If the center portion 30 of the boardlock was deformed flatly or having a curvature directed away from the board 60 e.g. as with the undeformed boardlock, then a pulling force on the boardlock would tend to pivot the center portion 30 away from the board 60 thus causing the outer portions 27 to collapse inwards, the boardlock thus being pulled through the hole 62.

Although the boardlock is flat and comprises relatively little material, especially in comparison to cylindrical shaped boardlocks, it is very strong because all of the forces are comprised within the plane of the sheet metal. This makes far more efficient use of the material strength than, for example, tabs bent transversely to the plane of the sheet metal.

The added thickness of the center portion 30 with respect to the first and second bridge portions 26, 28 serves to ensure correct inward arcuate deformation of the bridge portion and in particular to prevent buckling of the center portion 30 under the compressive forces that the second bridge portions 28 are subject to during the deformation process.

Elongate cavities 58 (see Figure 6) are provided in the connector housing for receiving the boardlock connector section 4, whereby the outer edges 14 of the guide arms 12 engage in an interference fit with the cavities 58, the retention barbs 16 preventing extraction of the boardlock therefrom. In order to further secure the boardlock to the housing, the deformable tab members 8 can be transversely bent (around axes substantially parallel to the axis of the board hole 62) into corresponding cavities of the connector whereby this bending is achieved once the boardlock is fully inserted into the cavity 58 by a special tool (stamping die) that is inserted through the windows 56 of the connector which are adjacent the deformable members 8 (see Figures 4 and 6). The inclined lower edge 9 of the tab 8 ensures that pivotable deformation thereof progressively engages and tightens the tab edge 9 against the shoulder 57 which eliminates play and securely retains the tab 8 against the shoulder 57.

As seen in Figure 4, the right angled connector 50 is for making electrical connection to a printed circuit board via the compliant pins 52. The compliant pins 52 have a pair of reversed C-shaped resilient arms that are resiliently biasable against electrical circuit traces that line corresponding holes of the printed circuit board thus making electrical contact therewith. This type of contact does not therefore require soldering, hence the need for a boardlock that correspondingly does not require soldering but nevertheless provides the reliability and strength of soldered boardlocks.

Referring to Figure 7, another embodiment of the boardlock is shown, similar to the boardlock of Figure 1 whereby the similar features are denoted by the same numbers with a prime. The main differences between the embodiment of Figure 7 and that of Figure 1, are the outwardly protruding bulges 70 along side the outer edge 14', the more pronounced lower central portion 30' and the tapered inner edges 72 adjacent the lower end of the ridged arms 22', the center portion 30' having an outer tapered profile 74 engageable against the tapered edges 72. The purpose of the bulges 70 on the outer edge 14', is to fit interferingly in a cavity 58 of a connector housing such that the boardlock 2' sits firmly therein without play. The purpose of the tapered edges 72, is to provide a surface against which the protruding central portion 30' abuts once the boardlock 2' has been deformed by the die as shown in Figure 9, whereby the tapered edges 74 of the central portion 30' abut against the tapered edges 72. The latter feature enhances the extraction force required to pull out the boardlock from the printed circuit board hole by wedging the central portion 30' between the ridged arms 22' hence preventing the arms 22' from collapsing together.

Advantageously therefore, due to the flat, simple construction of this boardlock, it is inexpensive and yet provides a strong mechanical connection without requiring an additional soldering step and is therefore ideally adapted to connectors that are assembled to the printed circuit board without soldering. The mechanical strength is further enhanced by the inwardly arcuate curvature of the deformed bridge portion. Additional advantages, are the simple assembly of the boardlock to a connector due to the deformable tabs, and the reduced space requirements, namely the flatness of the boardlock requires little extra length of the connector as opposed to for example, a cylindrical boardlock. This invention is also compatible with a soldering process whereby the advantages of cost, space, simplicity and reliability are still valid.

## Claims

1. A boardlock (2, 2') for mechanically fixing a connector (50) to a printed circuit board (60)
a) where the boardlock (2, 2') is a unitary edge-stamped sheet metal part comprising a U-shaped substantially planar and symmetrical board mounting section (6) and a connector mounting section (4);
b) the board mounting section (6) comprises a pair of arms (22, 22') joined at a lower end by a bridge portion (24),
c) whereby the arms (22, 22') are insertable in a hole (62) in the printed circuit board (60) and
d) whereby the bridge portion (24) is insertable through the hole (62) in the printed circuit board (60);
**characterized in that**
e) the arms (22, 22') are rigid arms;
f) the bridge portion is plastically deformable;
g) the bridge portion (24) has a portion (26, 28) that bulges outwards of the hole (62) for elastically engaging to the board (60) prior to deformation of the bridge portion (24); and
h) the bridge portion (24) is permanently deformable such that the board lock (2, 2') is securely holdable to the board (60) without requiring post-soldering.

2. The boardlock of claim 1 characterized in that
a) the bridge portion (24) is deformable into a substantially arcuate shape,
b) whereby a center portion (30, 30') of the bridge portion (24) is at a lesser distance to the printed circuit board (60) than the extremities of the arc.

3. The boardlock of any of the preceding claims characterized in that
a) the bridge portion (24) comprises a pair of deformable arms (26, 28) of less width than the rigid arms (22, 22'), and a center portion (30, 30') joining the arms;
b) whereby the center portion (30, 30') is of greater width than the deformable arms (26, 28)
c) and whereby the added thickness of the center portion (30, 30') is directed towards the board (60) such that the concave arcuate deformation of the bridge portion (24) is favorized.

4. The boardlock of claim 3 characterized in that the center portion (30') has obliquely slanted edges (74) wedgeable between tapered edges (72) adjacent a lower end of the rigid arms (22') when the boardlock (2') is deformably assembled to the board (60).

5. The boardlock of any of the preceding claims characterized in that
a) the bridge portion (24) has a pair of bridge arms (26, 28) having a first portion (26) attached respectively to the rigid arms (22),
b) the first portions extending obliquely outwards and downwardly therefrom, and
c) a second portion (28) departing respectively from the first portions (26) obliquely inwards and downwardly therefrom to join a center portion (30),
d) whereby a pair of portions (27) formed by the intersection of the first and second portions protrude outwardly beyond the hole diameter.

6. The boardlock of any of the preceding claims characterized in that the connector mounting section (4) is substantially planar to the board mounting section (6) just prior to assembly to the connector (50).

7. The boardlock of any of the preceding claims characterized in that the connector mounting section (4) comprises a pair of deformable tabs that engage in corresponding cavities (56) of the connector (50) for securely fixing the boardlock thereto.

8. The boardlock of any preceding claim characterized in that the connector mounting section (4) comprises tabs (8) deformable about axes substantially parallel to the axis of the board hole (62).

9. The boardlock of any preceding claim characterized in that the connector mounting section (4) comprises tabs (8) deformable through windows (56) of a connector (50) by a stamping die.

10. The boardlock of any of claims 7 to 9 characterized in that
a) the deformable tabs (8) comprise a lower edge (9) engageable against a shoulder (57) of a connector housing (51),
b) whereby the edge (9) is inclined with respect to the surface of the shoulder (57) such that the exterior portion of the tab edge (9) is farther from the shoulder surface than the inner portion of the tab edge (9).

## Patentansprüche

1. Plattensperre (2, 2') für das mechanische Befestigen eines Verbinders (50) an einer Leiterplatte (60),
a) worin die Plattensperre (2, 2') ein einheitliches kantengestanztes Blechteil ist, das aufweist: einen U-förmigen im wesentlichen planaren und symmetrischen Leiterplattenmontageabschnitt (6) und einen Verbindermontageabschnitt (4);
b) worin der Leiterplattenmontageabschnitt (6) ein Paar Arme (22, 22') aufweist, die an einem unteren Ende durch einen Brückenabschnitt (24) verbunden sind;
c) wodurch die Arme (22, 22') in ein Loch (62) in der Leiterplatte (60) einsetzbar sind; und
d) wodurch der Brückenabschnitt (24) durch das Loch (62) in der Leiterplatte (60) einsetzbar ist;
dadurch gekennzeichnet, daß
e) die Arme (22, 22') starre Arme sind;
f) der Brückenabschnitt plastisch verformbar ist;
g) der Brückenabschnitt (24) einen Abschnitt (26, 28) aufweist, der sich vom Loch (62) nach außen wölbt, um elastisch mit der Leiterplatte (60) vor der Verformung des Brückenabschnittes (24) in Eingriff zu kommen; und
h) der Brückenabschnitt (24) dauerhaft verformbar ist, so daß die Plattensperre (2, 2') sicher an der Leiterplatte (60) gehalten werden kann, ohne daß ein Nachlöten erforderlich ist.

2. Plattensperre nach Anspruch 1, dadurch gekennzeichnet, daß
a) der Brückenabschnitt (24) in eine im wesentlichen bogenförmige Form verformbar ist,
b) wodurch ein mittlerer Abschnitt (30, 30') des Brückenabschnittes (24) in einem geringeren Abstand zur Leiterplatte (60) vorhanden ist als die äußersten Enden des Bogens.

3. Plattensperre nach einem der vorhergehenden Ansprüche, dadurch gekennzeichnet, daß
a) der Brückenabschnitt (24) ein Paar verformbare Arme (26, 28) von geringerer Breite als die starren Arme (22, 22') aufweist, und ein mittlerer Abschnitt (30, 30') die Arme verbindet,
b) wodurch der mittlere Abschnitt (30, 30') eine größere Breite aufweist als die verformbaren Arme (26, 28),
c) und wodurch die zusätzliche Dicke des mittleren Abschnittes (30, 30') zu der Leiterplatte (60) hin liegt, so daß die konkave, bogenförmige Verformung des Brückenabschnittes (24) begünstigt wird.

4. Plattensperre nach Anspruch 3, dadurch gekennzeichnet, daß der mittlere Abschnitt (30') schräg geneigte Ränder (74) aufweist, die zwischen kegelförmigen Rändern (72), angrenzend an ein unteres Ende der starren Arme (22'), verkeilbar sind, wenn die Plattensperre (2') an der Leiterplatte (60) verformbar montiert wird.

5. Plattensperre nach einem der vorhergehenden Ansprüche, dadurch gekennzeichnet, daß
a) der Brückenabschnitt (24) ein Paar Brückenarme (26, 28) aufweist, bei denen ein erster Abschnitt (26) entsprechend an den starren Armen (22) befestigt ist;
b) sich die ersten Abschnitte schräg nach außen und nach unten von dort aus erstrecken; und
c) ein zweiter Abschnitt (28) entsprechend von den ersten Abschnitten (26) schräg nach innen und unten von dort abweicht, um einen mittleren Abschnitt (30) zu verbinden;
d) wodurch ein Paar Abschnitte (27), die durch Schneiden des ersten und zweiten Abschnittes gebildet werden, nach außen über den Lochdurchmesser hinaus vorsteht.

6. Plattensperre nach einem der vorhergehenden Ansprüche, dadurch gekennzeichnet, daß der Verbindermontageabschnitt (4) im wesentlichen planar zum Leiterplattenmontageabschnitt (6) gerade vor der Montage am Verbinder (50) ist.

7. Plattensperre nach einem der vorhergehenden Ansprüche, dadurch gekennzeichnet, daß der Verbindermontageabschnitt (4) ein Paar verformbare Nasen aufweist, die in entsprechenden Hohlräumen (56) des Verbinders (50) in Eingriff kommen, um die Plattensperre daran sicher zu befestigen.

8. P1 attensperre nach vorhergehenden Ansprüchen, dadurch gekennzeichnet, daß der Verbindermontageabschnitt (4) Nasen (8) aufweist, die um Achsen im wesentlichen parallel zur Achse des Leiterplattenloches (62) herum verformbar sind.

9. Plattensperre nach vorhergehenden Ansprüchen, dadurch gekennzeichnet, daß der Verbindermontageabschnitt (4) Nasen (8) aufweist, die durch Fenster (56) eines Verbinders (50) mittels eines Stanzwerkzeuges verformbar sind.

10. Plattensperre nach einem der Ansprüche 7 bis 9, dadurch gekennzeichnet, daß
a) die verformbaren Nasen (8) einen unteren Rand (9) aufweisen, der an einem Vorsprung (57) eines Verbindergehäuses (51) in Eingriff kommen kann,
b) wodurch der Rand (9) mit Bezugnahme auf die Fläche des Vorsprunges (57) derartig geneigt wird, daß der äußere Abschnitt des Nasenrandes (9) weiter von der Vorsprungfläche entfernt ist als der innere Abschnitt des Nasenrandes (9).

## Revendications

1. Dispositif de verrouillage de plaquette (2, 2') pour fixer mécaniquement un connecteur (50) à une plaquette de circuit imprimée (60)
a) le dispositif de verrouillage de plaquette (2, 2') étant une pièce de tôle métallique unitaire à estampage latéral comprenant une section de montage de la plaquette en U pratiquement plane et symétrique (6) et une section de montage du connecteur (4);
b) la section de montage de la plaquette (6) comprenant une paire de bras (22, 22') reliés au niveau d'une extrémité inférieure par une partie de pontage (24);
c) les bras (22, 22') pouvant ainsi être insérés dans un trou (62) dans la plaquette de circuit imprimée (60); et
d) la partie de pontage (24) pouvant ainsi être insérée à travers le trou (62) dans la plaquette de circuit imprimée (60);
caractérisé en ce que
e) les bras (22, 22') sont des bras rigides;
f) la partie de pontage peut être soumise à une déformation plastique;
g) la partie de pontage (24) comporte une partie (26, 28), bombée vers l'extérieur du trou (62) en vue d'un engagement élastique dans la plaquette (60) avant la déformation de la partie de pontage (24); et
h) la partie de pontage (24) peut être soumise à une déformation permanente, de sorte que le dispositif de verrouillage de plaquette (2, 2') peut être retenu fermement sur la plaquette (60), sans exiger une soudure ultérieure.

2. Dispositif de verrouillage de plaquette selon la revendication 1, caractérisé en ce que
a) la partie de pontage (24) peut être déformée en une forme pratiquement arquée,
b) une partie centrale (30, 30') de la partie de pontage (24) étant ainsi séparée de la plaquette de circuit imprimée (60) d'une distance inférieure à celle des extrémités de l'arc.

3. Dispositif de verrouillage de plaquette selon l'une quelconque des revendications précédentes, caractérisé en ce que
a) la partie de pontage (24) comprend une paire de bras déformables (26, 28) ayant une largeur inférieure à celle des bras rigides (22, 22') et une partie centrale (30, 30') reliant les bras;
b) la partie centrale (30, 30') ayant ainsi une largeur supérieure à celle des bras déformables (26, 28);
c) et l'épaisseur additionnelle de la partie centrale (30, 30') étant dirigée vers la plaquette (60), de sorte que la déformation arquée concave de la partie de pontage (24) est favorisée.

4. Dispositif de verrouillage de plaquette selon la revendication 3, caractérisé en ce que la partie centrale (30') comporte des bords inclinés obliquement (74), pouvant être serrés contre les bords effilés (72) adjacents à une extrémité inférieure des bras rigides (22') lorsque le dispositif de verrouillage de plaquette (2') est assemblé par déformation sur la plaquette (60).

5. Dispositif de verrouillage de plaquette selon l'une quelconque des revendications précédentes, caractérisé en ce que
a) la partie de pontage (24) comprend une paire de bras de pontage (26, 28) comportant une première partie (26) fixée respectivement aux bras rigides (22),
b) les premières parties s'étendent obliquement vers l'extérieur et vers le bas à partir de ceux-ci, et
c) une deuxième partie (28) s'étend respectivement à partir des premières parties (26), obliquement vers l'intérieur et vers le bas pour rejoindre une partie centrale (30),
d) une paire de parties (27) formées par l'intersection des premières et deuxièmes parties débordent ainsi vers l'extérieur au-delà du diamètre du trou.

6. Dispositif de verrouillage de plaquette selon l'une quelconque des revendications précédentes, caractérisé en ce que la section de montage du connecteur (4) est pratiquement plane par rapport à la section de montage de la plaquette (6) juste avant l'assemblage au connecteur (50).

7. Dispositif de verrouillage de plaquette selon l'une quelconque des revendications précédentes, caractérisé en ce que la section de montage du connecteur (4) comprend une paire de pattes déformables s'engageant dans des cavités correspondantes (56) du connecteur (50) pour y fixer fermement le dispositif de verrouillage de plaquette.

8. Dispositif de verrouillage de plaquette selon l'une quelconque des revendications précédentes, caractérisé en ce que la section de montage du connecteur (4) comprend des pattes (8) pouvant être déformées autour d'axes pratiquement parallèles à l'axe du trou de la plaquette (62).

9. Dispositif de verrouillage de plaquette selon l'une quelconque des revendications précédentes, caractérisé en ce que la section de montage du connecteur (4) comprend des pattes (8) pouvant être déformées à travers les fenêtres (56) d'un connecteur (50) par une matrice d'estampage.

10. Dispositif de verrouillage de plaquette selon l'une quelconque des revendications 7 à 9, caractérisé en ce que
a) les pattes déformables (8) comprennent un bord inférieur (9) pouvant être engagé contre un épaulement (57) d'un boîtier de connecteur (51),
b) le bord (9) est ainsi incliné par rapport à la surface de l'épaulement (57), de sorte que la partie externe du bord de la patte (9) est plus éloignée de la surface de l'épaulement que la partie interne du bord de la patte (9).
